Europäisches Patentamt

European Patent Office

Office européen des brevets

(11) Publication number: **0 416 873 A2**

# EUROPEAN PATENT APPLICATION

(21) Application number: 90309665.9

(51) Int. Cl.⁵: **G03F 7/022**, G03F 7/004

(22) Date of filing: 04.09.90

(30) Priority: 05.09.89 US 403223

(43) Date of publication of application:
13.03.91 Bulletin 91/11

(84) Designated Contracting States:
DE FR GB IT NL

(71) Applicant: HOECHST CELANESE
CORPORATION
Route 202-206 North
Somerville, New Jersey(US)

(72) Inventor: Osuch, Christopher E.
151A Randolph Avenue
Mine Hill, New Jersey(US)
Inventor: McFarland, Michael J.
R.D. 3 Box 247
Washington New Jersey(US)

(74) Representative: De Minvielle-Devaux, Ian
Benedict Peter et al
CARPMAELS & RANSFORD 43, Bloomsbury
Square
London WC1A 2RA(GB)

(54) Transparent dissolution rate modifiers for photoresists.

(57) A photosensitive composition containing an alkali soluble resin, a quinone diazide compound and a transparent, hydrophobic plasticizer which is preferably a dihydroabietyl phthalate, in a solvent mixture. After drying and imagewise exposing, the composition is developed to produce a photoresist image.

## BACKGROUND OF THE INVENTION

The present invention relates generally to radiation sensitive photoresist compositions and particularly to compositions containing aqueous alkali soluble resins together with sensitizing agents.

It is well known in the art to produce positive photoresist formulations such as those described in United States Patent Nos. 3,666,473, 4,115,128 and 4, 173,470. These include alkali soluble phenol-formaldehyde novolak resins together with light sensitive materials, usually a substituted naphthoquinone diazide compound. The resins and sensitizers are dissolved in an organic solvent or mixture of solvents and are applied as a thin film or coating to a substrate suitable for the particular application desired. The resin component of these photoresist formulations is soluble in aqueous alkaline solutions, but the naphthoquinone sensitizer is not. Upon imagewise exposure of the coated substrate to actinic radiation the sensitizer is rendered more soluble than the unexposed areas. This difference in solubility rates causes the exposed areas of the photoresist coating to be dissolved when the substrate is immersed in an alkaline developing solution while the unexposed areas are largely unaffected, thus producing a positive relief pattern on the substrate.

In most instances, the exposed and developed substrate will be subjected to treatment by a substrate-etchant solution. The photoresist coating protects the coated areas of the substrate from the etchant and thus the etchant is only able to etch the uncoated areas of the substrate, which in the case of a positive photoresist, correspond to the areas that were exposed to actinic radiation. Thus, an etched pattern can be created on the substrate which corresponds to the pattern on the mask, stencil, template, etc., that was used to create selective exposure patterns on the coated substrate prior to development. The relief pattern of the photoresist on the substrate produced by the method described above is useful for various applications including as an exposure mask or a pattern such as is employed in the manufacture of miniaturized integrated electronic components.

Photoresists are generally categorized as being either positive working or negative working. In a negative working resist composition, the imagewise light struck areas harden and form the image areas of the resist after removal of the unexposed areas with a developer. In a positive working resist the exposed areas are the non-image areas. The light struck parts are rendered soluble in aqueous alkali developers. While negative resists are the most widely used for industrial production of printed circuit boards, positive resists are capable of much finer resolution and smaller imaging geometries. Hence positive resists are the choice for the manufacture of densely packed integrated circuits.

In the production of photoresists it is important to have a very high contrast between the exposed and unexposed portions. The photoresist composition normally contains a photosensitizer, a water insoluble aqueous alkaline soluble resin, a solvent composition plus optional additional ingredients as will be discussed hereinafter. It has now been unexpectedly found that the contrast between the exposed and unexposed areas can be improved by the inclusion of a minor amount, usually from about 0.5% to about 20% of a dissolution rate modifier which is a hydrophobic, film forming high melting point plasticizer which is substantially transparent at the U.V. wavelength at which the sensitizer absorbs actinic radiation.

Existing photoresists often produce lines having undesired variations in width across topographic features. This so-called "necking" can create problems during subsequent processing steps. Therefore, reducing or eliminating this necking effect is desirable. Previously, it has been shown that the addition of certain dyes, such as coumarin 6, to the resist solution before the resist is coated on the substrate will reduce necking. This has been ascribed to the absorbency of the dye which is said to reduce the amount of light scattered from the non-planar surfaces and to increase the contrast of the resist. It has been found that U.V. transparent additives such as dihydroabietyl phthalate will also improve resist performance. Thus the dissolution rate ratio between an unirradiated and an irradiated resist film is increased by the additives' presence. This improvement in dissolution rate ratio manifests itself as a decrease in unirradiated film loss, for a given developer, or in the need for a stronger developer for a given development time. In addition, improved adhesion of the resist film to the substrate is an added benefit under certain circumstances. This dissolution rate inhibitor also increases resist hydrophobicity.

Among the additional advantages realized by this highly desirable result are improvement in resistance of image areas to developers, i.e. reduced film loss, crack prevention, improved process latitude, improvement in developed image contrast and improved adhesion between the photoresist and commonly used substrates.

## SUMMARY OF THE INVENTION

The invention provides a photosensitive composition which comprises in admixture a water insoluble, aqueous alkali soluble binder resin in an amount sufficient to form a uniform film of the composition components when it is coated on a substrate and dried; a photosensitive component selected from the group consisting of o-quinone diazides, onium salts, compounds having a diazo-1,3 dione group, and a combination of a compound capable of generating an acid upon exposure to sufficient activating energy, and a compound containing at least one C-O-C bond which can be split by an acid, said photosensitive component being present in an amount sufficient to uniformly photosensitize the composition; and a hydrophobic plasticizer which is substantially transparent to ultraviolet radiation and has a softening point in the range of from about $50^\circ$ C to about $70^\circ$ C, in an amount sufficient to reduce the dissolution rate of a dried film of the composition with an aqueous alkaline developer, compared to the same composition without the plasticizer.

The invention also provides a photographic element comprising a dried film of the foregoing composition on a substrate. The invention further provides a method for producing a photographic image comprising imagewise exposing and developing the aforesaid photographic element.

## DETAILED DESCRIPTION OF THE PREFERRED EMBODIMENT

As a first step in the production of the photographic element of the present invention, one coats and dries the foregoing photosensitive composition on a suitable substrate. In the preferred embodiment the composition contains a solvent, a water insoluble, aqueous alkaline soluble binding resin, quinone diazide photosensitizer and u.v. transparent plasticizer. The binding resins include the classes known as the novolaks, substituted and unsubstituted polyvinyl phenols, maleimide homopolymers and copolymers described in EPA 140273 (84112439.9) corresponding to USSN 547815, EPA 234327 (87101252.2) corresponding to USSN 832116, and USSN 052950 filed 22 May 1987; t-butylstyrene maleimide copolymers, and the poly(p-tert-butoxycarbonyloxystyrenes) described in U.S. 4,491,620 all of which are incorporated herein by reference.

The production of novolak resins, which may be used for preparing photosensitive compositions, is well known in the art. A procedure for their manufacture is described in Chemistry and Application of Phenolic Resins , Knop A. and Scheib, W.; Springer Verlag, New York, 1979 in Chapter 4 which is incorporated herein by reference. Polyvinyl phenols are taught in U.S. 3,869,292 and 4,439,516, which are incorporated herein by reference. Useful binder resins include copolymers of styrene, t-butyl styrene, alpha-methylstyrene or 2,4-di($C_1$-$C_5$ alkyl)styrene and maleimide and, optionally their terpolymers with N-($C_1$-$C_5$ alkyl)-maleimide as described in U.S. patent application 06/547,815. Useful binders also include the foregoing copolymers wherein a portion of the N-H groups of the maleimide have been replaced with an acid labile group such as a tert-butoxy carbonyl group as taught in U.S. Patent application serial number 06/832,116. Still further useful binder resins are polymers containing imide groups blocked by a methylol group or substituted methylol group and further blocked to form an acetal or ketal moiety as taught in U.S. patent application 07/052,950. Preferred are the polymers disclosed in co-pending application U.S. Serial No. 06/832,116. Examples of such polymers are N-tert -butyloxycarbonyl maleimide/styrene copolymer, N-tert -butyloxycarbonyl maleimide homopolymer, N-tert -butyloxycarbonyl maleimide/vinyl ether copolymers where the vinyl ether is aliphatic from 3 (methyl vinyl ether) to 20 (octadecylvinyl ether) carbon atoms, N-tert -butyloxycarbonyl maleimide/2,4-disubstituted styrene copolymers where the styrene is substituted at the 2 and 4 positions with, independently, C1 to C5 alkyl groups or H. Other polymers which may be used include those in which a phenol containing polymer has the hydroxyl functionalities blocked with an acid-labile group such as poly( tert -butyloxycarbonyl-alpha-alkyl styrene) or a copolymer thereof, poly( tert -butyloxycarbonyloxy styrene) or a copolymer thereof, or polymers containing other acidic imide functionalities (-CO-NH-CO-) blocked by an acid labile group such as poly(dimethyl-N-tert -butyloxycarbonyl glutarimide), or polymers containing carboxylic acid functionalities blocked by an acid labile group such as poly( tert -butyl p-vinylbenzoate) or a copolymer thereof, poly( tert -butyl methacrylate) or a copolymer thereof, and the like. Other blocking groups may be present on the polymers to yield materials useful for the method of the invention. Similarly, the use of o-quinone diazides is well known to the skilled artisan as demonstrated by Light Sensitive Systems , Kosar, J.; John Wiley & Sons, New York, 1965 in Chapter 7.4 which is also incorporated herein by reference. These sensitizers which comprise a component of the present resist compositions of the present invention are preferably selected from the group of substituted naphthoquinone diazide sensitizers which are conventionally used in the art in positive photoresist formulations. Such sensitizing compounds are disclosed, for example, in United States Letters Patent Nos. 2,797,213; 3,106,465; 3,148,983; 3,130,047; 3,201,329; 3,785,825; and 3,802,885, which are incorporated herein by reference.

The preferred photosensitizer is a 1,2 quinone diazide -4- or -5-sulfonic acid ester of a phenolic derivative. It presently appears that the number of fused rings is not important for this invention but the position of the sulfonyl group is important. That is, one may use benzoquinones, naphthoquinones or anthroquinones as long as the oxygen is in the 1 position, diazo is in the 2 position and the sulfonyl group is in the 4 or 5 position. Likewise the phenolic member to which it is attached does not appear to be important. For example it can be a cumylphenol derivative as taught in U.S. 3,640,992 or it can be a mono-, di-, or tri-hydroxyphenyl alkyl ketone or benzophenone as shown in U.S. 4,499,171. Both of these patents are incorporated herein by reference.

The photosensitive component may also comprise a combination of a compound capable of generating an acid upon exposure to actinic radiation and a compound containing at least one C-O-C bond which can be split by an acid. Such a combination of compounds non-exclusively includes those taught in U.S. 4,101,323, incorporated herein by reference. Onium salts include sulfonium, diazonium and iodonium salts. Sulfonium salts are described in U.S. 4,537,854; diazonium salts are described in KOSAR. Iodonium salts are described in U.S. Patent 4,603,101. Compounds having the diazo-1,3 dione group are disclosed in U.S. 4,522,911; 4,339,522; 4,284,706; 4,622,283; 4,735,885 and 4,626,491 which are incorporated by reference.

The dissolution rate modifying plasticizers which are useful for this invention are hydrophobic, film forming plasticizers, which are substantially transparent at the wavelength at which the photosensitive component absorbs U.V. radiation. The most preferred compound is dihydroabietyl phthalate which has a melting point of about 60° C. It is preferably present in the photosensitive composition in an amount of from about 0.5% to about 20% based on the weight of the non-solvent parts of the composition. A more preferred range is from about 2% to about 18% by weight.

The photosensitive composition is formed by blending the ingredients in a suitable solvent composition. In the preferred embodiment the resin is preferably present in the overall composition in an amount of from about 75% to about 98.5% based on the weight of the solid, i.e. non-solvent parts of the composition. A more preferred range of resin would be from about 80% to about 90% and most preferably from about 82% to about 85% by weight of the solid composition parts. The photosensitive component is preferably present in an amount ranging from about 1% to about 25% based on the weight of the solid, i.e., non-solvent parts of the composition. A more preferred range of the photosensitive component would be from about 1% to about 20% and more preferable from about 10% to about 18% by weight of the solid composition parts. In manufacturing the composition the resin, dihydroabietyl phthalate and photosensitive component are mixed with such solvents as propylene glycol alkyl ether or its acetate, butyl acetate, diglyme, xylene, ethylene glycol monoethyl ether acetate, and most preferably propylene glycol methyl ether acetate, among others.

Additives such as colorants, dyes, anti-striation agents, leveling agents, plasticizers, adhesion promoters, speed enhancers, and such surfactants as non-ionic surfactants may be added to the solution of resin, sensitizer, and solvent before the solution is coated onto a substrate.

Examples of dye additives that may be used together with the photoresist compositions of the present invention include Methyl Violet 2B (C.I. No. 42535), Crystal Violet (C.I. 42555), Malachite Green (C.I. No. 42000), Victoria Blue B (C.I. No. 44045) and Neutral Red (C.I. No. 50040) at one to ten percent weight levels, based on the combined weight of the solid parts of the composition. The dye additives help provide increased resolution by inhibiting back scattering of light off the substrate.

Anti-striation agents may be used up to five percent weight level, based on the combined weight of solids.

Additional plasticizers which may be used include, for example, phosphoric acid tri-(beta-chloroethyl)-ester; stearic acid; dicamphor; polypropylene; acetal resins; phenoxy resins; and alkyl resins at one to ten percent weight levels, based on the combined weight of solids. The plasticizer additives improve the coating properties of the material and enable the application of a film that is smooth and of uniform thickness to the substrate.

Adhesion promoters which may be used include, for example, beta-(3,4-epoxy-cyclohexyl)-ethyltrimethoxysilane; p-methyl-disilanemethyl methacrylate; vinyltrichlorosilane; and gamma-amino-propyl triethoxysilane up to a 4 percent weight level, based on the combined weight of solids.

Speed enhancers that may be used include, for example, picric acid, nicotinic acid or nitrocinnamic acid at a weight level of up to 20 percent, based on the combined weight of resin and solids. These enhancers tend to increase the solubility of the photoresist coating in both the exposed and unexposed areas, and thus they are used in applications when speed of development is the overriding consideration even though some degree of contrast may be sacrificed; i.e., while the exposed areas of the photoresist coating will be dissolved more quickly by the developer, the speed enhancers will also cause a larger loss of photoresist coating from the unexposed areas.

The coating solvents may be present in the overall composition in an amount of up to about 95% by weight of the composition. Preferably, the solvent content is such that the total solids comprise about 5% to about 50% by weight of the overall composition. Non-ionic surfactants that may be used include, for example, nonylphenoxy poly(ethyleneoxy)ethanol; octylphenoxy(ethyleneoxy)ethanol; and dinonyl phenoxy poly(ethyleneoxy)ethanol at up to 10 percent weight, based on the combined weight of solids.

The prepared resist solution can be applied to a substrate by any conventional method used in the photoresist art, including dipping, spraying, whirling and spin coating. When spin coating, for example, the resist solution can be adjusted for the percentage of solids content in order to provide coatings of the desired thickness given the type of spinning equipment utilized and the amount of time allowed for the spinning process. Suitable substrates include silicon, aluminum or polymeric resins, silicon dioxide, doped silicon dioxide, silicon nitride, tantalum, copper, polysilicon, ceramics, aluminum/copper mixtures, gallium arsenide and other such Group III/V compounds. The substrate may have an adhesion promoted layer of a suitable composition such as hexa-alkyldisilazane.

The photoresist coatings produced by the above described procedure are particularly suitable for application to thermally grown silicon/silicon dioxide-coated wafers such as are utilized in the production of microprocessors and other miniaturized integrated circuit components. An aluminum/aluminum oxide wafer can be used as well. The substrate may also comprise various polymeric resins especially transparent polymers such as polyesters.

After the resist composition solution is coated onto the substrate, the substrate is temperature treated at approximately 20° to 100°C. This temperature treatment is selected in order to reduce and control the concentration of residual solvents in the photoresist while not causing substantial thermal degradation of the photosensitizer. In general one desires to minimize the concentration of solvents and thus this temperature treatment is conducted until substantially all of the solvents have evaporated and a thin coating of photoresist composition, on the order of a micron in thickness, remains on the substrate. This treatment is normally conducted at temperatures in the range of from about 20° to about 100°C. In a preferred embodiment the temperature is conducted at from about 50° to about 90°C. A more preferred range is from about 70° to about 90°C. This treatment is conducted until the rate of change of solvent removal becomes relatively insignificant. The temperature and time selection depends on the resist properties desired by the user as well as equipment used and commercially desired coating times. Commercially acceptable treatment times for hot plate treatment are those up to about 3 minutes, more preferably up to about 1 minute. In one example, a 30 second treatment at 90° is useful. The coating substrate can then be exposed to actinic radiation, especially ultraviolet radiation, in any desired pattern, produced by use of suitable masks, negatives, stencils, templates, etc. in a manner well known to the skilled artisan. Exposure may be by electron beam or x-ray but the most preferred exposure is with ultraviolet radiation, especially deep ultraviolet radiation, i.e. at a wavelength of from about 220 -260 nm.

The exposed resist-coated substrate is next immersed in a suitable developing solution. The solution is preferably agitated, for example, by nitrogen burst agitation. The substrates are allowed to remain in the developer until all, or substantially all, of the resist coating has dissolved from the exposed areas. Suitable developers include aqueous alkaline solutions such as those including sodium hydroxide, and tetramethyl ammonium hydroxide as are well known in the art. 0.1N to 0.3N solutions are useful. The more dissolution rate modifier that is added, the stronger the developer concentration required.

After removal of the coated wafers from the developing solution, an optional post-development heat treatment or bake may be employed to increase the coating's adhesion and chemical resistance to etching solutions and other substances. The post-development heat treatment can comprise the oven baking of the coating and substrate below the coating's softening point. In industrial applications, particularly in the manufacture of microcircuitry units on silicon/silcon dioxide-type substrates, the developed substrates may be treated with a buffered, hydrofluoric acid base etching solution. The resist compositions of the present invention are resistant to acid-base etching solutions and provide effective protection for the unexposed resist-coated areas of the substrate.

The following example will provide an illustration of the present invention. This example is not intended, however, to limit or restrict the scope of the invention in any way.

Example

5

The following tests are performed to determine the effect of film-forming additives (high melting point plasticizers) on the dissolution rates of a resist film.

A stock solution is prepared as follows:

26.25 gm Diglyme

10.00 gm Maleimide/t-butyl styrene copolymer

1.25 gm of the condensation product of 2,4 dihydroxy-benzophenone with 2-diazo-1-naphthol-4-sulfonyl chloride.

The mixture is filtered to 0.2 um with a PTFE filter. Some amount of diazide is filtered off.

The stock solution is divided up into aliquots of 3.75 gm each (1 gm resin, 0.125 gm sensitizer, 2.625 gm diglyme) with some remainder.

Celloyn 21 brand dihydroabietyl phthalate is added to give the following ratios of resin to plasticizer

| Ratio of Resin to Plasticizer | Amount of Plasticizer | Plasticizer as fraction of total weight of solids | |
|---|---|---|---|
| 25:1 | 0.040 gm | .034 | |
| 20:1 | 0.050 | .043 | |
| 15:1 | 0.066 | .055 | |
| 10:1 | 0.100 | .082 | |
| 7:1 | 0.143 | .113 | |
| 5:1 | 0.200 | .151 | (plus 0.19 gm diglyme) |
| 4:1 | 0.250 | .182 | (plus 0.30 gm diglyme) |

No further filtering is done after addition of the plasticizer.

A series of silicon wafers are vapor treated with a hexamethyl disilazane adhesion promoter. The foregoing solutions are spun on the treated wafers and heat treated for 43 minutes at 80°C. They are exposed with varying amounts of 360 nm radiation through a broad band filter and developed with 0.25N potassium hydroxide with the following results:

6

| Comp. | Irrad | Initial Thickness | Final Thickness | Time | Develop Rate | Devopment Rate Ratio |
|---|---|---|---|---|---|---|
| | $mJ/cm^2$ | nm | nm | sec | nm/s | Irr/Non-Irr |
| 25:1 | 50 | 992 | 0 | 15 | 66 | 7.10 |
| 25:1 | 25 | 992 | 0 | 25 | 40 | 4.30 |
| 25:1 | 0 | 992 | 713 | 30 | 9.3 | - |
| 20:1 | 50 | 1000 | 0 | 19 | 53 | 7.07 |
| 20:1 | 25 | 1000 | 0 | 32 | 31 | 4.13 |
| 20:1 | 0 | 1000 | 731 | 36 | 7.5 | - |
| 15:1 | 50 | 1011 | 0 | 24 | 42 | 7.45 |
| 15:1 | 25 | 1011 | 0 | 42 | 24 | 4.26 |
| 15:1 | 0 | 1011 | 729 | 50 | 5.6 | - |
| 10:1 | 50 | 1018 | 0 | 39 | 26 | 8.39 |
| 10:1 | 25 | 1018 | 0 | 74 | 14 | 4.42 |
| 10:1 | 0 | 1018 | 769 | 80 | 3.1 | - |
| 7:1 | 50 | 986 | 0 | 64 | 15 | 9.91 |
| 7:1 | 25 | 986 | 0 | 124 | 8.0 | 5.12 |
| 7:1 | 0 | 986 | 784 | 130 | 1.6 | - |
| 5:1 | 50 | 962 | 0 | 144 | 6.7 | 10.43 |
| 5:1 | 25 | 962 | 0 | 290 | 3.3 | 5.17 |
| 5:1 | 0 | 962 | 776 | 290 | 0.64 | - |
| 4:1 | 50 | 985 | 0 | 292 | 3.4 | 11.6 |
| 4:1 | 25 | 985 | 0 | 620 | 1.6 | 5.48 |
| 4:1 | 0 | 985 | 805 | 620 | 0.29 | - |
| Control | 50 | 1007 | 0 | 8 | 126 | 6.63 |
| Control | 25 | 1007 | 0 | 14 | 72 | 3.79 |
| Control | 0 | 1007 | 626 | 20 | 19 | - |

From these results one can note increasing contrast and a decreasing development rate as the amount of dihydroabietyl phthalate is increased.

**Claims**

1. A photosensitive composition which comprises in admixture a water insoluble, aqueous alkali soluble binder resin in an amount sufficient to form a uniform film of the composition components when it is coated on a substrate and dried; a photosensitive component selected from o-quinone diazides, onium salts, compounds having diazo-1,3 dione group, and a combination of a compound capable of generating a strong acid upon exposure to sufficient activating energy and a compound containing at least one C-O-C bond which can be split by an acid, said photosensitive component being present in an amount sufficient to uniformly photosensitize the composition; and a hydrophobic plasticizer which is substantially transparent to ultraviolet radiation, and has a softening point in the range 50°C to 70°C, in an amount sufficient to reduce the dissolution rate of a dried film of the composition with an aqueous alkaline developer, compared to the same composition without the plasticizer.

2. The composition of claim 1 wherein said binder resin is present in the composition in an amount of 75% to 98.5%, the photosensitive component is present in an amount of 1% to 20% and the hydrophobic plasticizer is present in an amount of 0.5% to 20% based on the weight of the non-solvent parts of the photosensitive composition.

3. The composition of claim 1 or 2 wherein the binder resin is selected from novolaks, polyvinyl phenols; copolymers of styrene, 4-methyl styrene, 4-ethyl styrene, t-butyl styrene, alpha-methylstyrene or 2,4-di($C_1$-$C_5$ alkyl) styrene and maleimide and their terpolymers with N-($C_1$-$C_5$ alkyl)maleimide, the foregoing copolymers wherein a portion of the N-H groups of the maleimide have been replaced with an acid labile group; and polymers containing imide groups blocked by a methylol group or substituted methylol group and further blocked to form an acetal or ketal moiety.

4. The composition of any of claims 1-3 wherein the photosensitive component is an 0-quinone diazide.

7

5. The composition of any of claims 1-3 wherein said photosensitive component is a trihydroxybenzophenone-1,2- naphthoquinone diazide-4 or 5-sulfonic acid trisester.

6. The composition of any of claims 1-5 further comprising a solvent which comprises propylene glycol alkyl ether acetate or diglyme.

7. The composition of any of claims 1-6 further comprising one or more compounds selected from colorants, dyes, anti-striation agents, leveling agents, plasticizers, adhesion promoters, speed enhancers, and surfactants.

8. The composition of any of claims 1-7 wherein said hydrophobic plasticizer is dihydroabietyl phthalate.

9. A photographic element which comprises a substrate and a dried photosensitive composition substantially uniformly coated on said substrate which photosensitive composition is in accordance with any of claims 1-8.

10. The element of claim 9 wherein said substrate is selected from silicon, aluminum or polymeric resins, silicon dioxide, doped silicon dioxide, silicon nitride, tantalum, copper polysilicon, ceramics, aluminum/copper mixtures, gallium arsenide and Group III/V compounds.

11. The element of claim 9 or 10 further comprising a layer of an adhesion promoting composition between the substrate and the photosensitive composition.

12. The element of claim 11 wherein the adhesion promoting composition contains hexa-alkyldisilazane.

13. A process for preparing a photographic image which comprises in order:

a) forming a composition which comprises in admixture, a water insoluble, aqueous alkali soluble binder resin in an amount sufficient to form a uniform film of the composition components when it is coated on a substrate and dried; a photosensitive component selected from the group consisting of o-quinone diazides, onium salts, compounds having a diazo-1,3 dione group, and a combination of a compound capable of generating a strong acid upon exposure to sufficient activating energy and a compound containing at least one C-O-C bond which can be split by an acid, said photosensitive component being present in an amount sufficient to uniformly photosensitize the composition; and a hydrophobic plasticizer which is substantially transparent to ultraviolet radiation, and has a softening point in the range of from about 50°C to about 70°C, in an amount sufficient to reduce the dissolution rate of a dried film of the composition with an aqueous alkaline developer, compared to the same composition without the plasticizer; and a solvent selected from the group consisting of propylene glycol monoalkyl ether, propylene glycol monoalkyl ether acetate, butyl acetate, diglyme, xylene and ethylene glycol monoalkyl ether acetate;

b) coating said composition on a substrate; and

c) heating said coated substrate at a temperature of 20°C to 100°C until substantially all of said solvent is dried off; and

d) imagewise exposing said composition to ultraviolet, electron beam, ion beam or x-ray radiation; and

e) removing the non-image areas of said composition with an aqueous alkaline developer solution.

14. The process of claim 13 wherein said exposing step is conducted with ultraviolet radiation in the range of 190 to 450 nm.

15. The process of claim 13 or 14 wherein said developer comprises sodium hydroxide and/or tetramethyl ammonium hydroxide.

16. The process of any of claims 13-15 wherein said substrate is selected from silicon, aluminum or polymeric resins, silicon dioxide, doped silicon dioxide, silicon nitride, tantalum, copper, polysilicon, ceramics, aluminum/copper mixtures, gallium arsenide and Group III/V compounds.

17. The process of any of claims 13-16 further comprising a layer of an adhesion promoting composition between the substrate and the photosensitive composition.

18. The process of claim 17 wherein the adhesion promoting composition contains hexa-alkyldisilazane.

19. The process of any of claims 13-18 wherein said composition is in accordance with any of claims 2-8.